# EUROPÄISCHE PATENTANMELDUNG

(11) **EP 2 104 148 A2**
(43) Veröffentlichungstag der Anmeldung: **23.09.2009**
(21) Anmeldenummer: 09003599.9
(22) Anmeldetag: 12.03.2009
(51) Int. Cl.: H01L 31/18, B23K 26/04, B23K 26/16, B23K 26/40, B23K 26/18

(54) **Verfahren zur Herstellung eines photovoltaischen Moduls mit einem Infrarot-laser**

(30) Priorität: 19.03.2008 DE 102008014948
(71) Anmelder: SCHOTT Solar AG, 55122 Mainz (DE)
(72) Erfinder: Psyk, Walter, 81371 München (DE); Lechner, Peter, 85591 Vaterstetten (DE)
(74) Vertreter: Haft, von Puttkamer, Berngruber

(57) **Zusammenfassung**

Zur Herstellung eines photovoltaischen Moduls (1), das auf einem transparenten Substrat (2) eine transparente Frontelektrodenschicht (3) eine Halbleiterschicht (4) und eine Rückelektrodenschicht (5) als Funktionsschichten aufweist, werden die Funktionsschichten (3 - 5) im Randbereich (10) des Substrats (2) mit einem Laser entfernt, der eine Infrarotstrahlung emittiert. Anschließend wird auf das beschichtete Substrat (2) mit einer Klebefolie (11) eine Rückseitenabdeckung (12) laminiert.

## Beschreibung

Die Erfindung bezieht sich auf ein Verfahren zur Herstellung eines photovoltaischen Moduls nach dem Oberbegriff des Anspruchs 1.

Um beim Betrieb eines photovoltaischen Moduls eine hinreichende elektrische Isolation der unter Spannung stehenden Funktionsschichten gegenüber der Umgebung (Rahmen, Montagegestell, Aufständerung) insbesondere im feuchten oder nassen Zustand zu gewährleisten, müssen vor dem Auflaminieren der Rückenseitenabdeckung mit der Klebefolie die Funktionsschichten am Rand des Moduls von dem Substrat umlaufend entfernt werden, so dass die Rückenseitenabdeckung mit der Klebefolie im Randbereich direkt mit dem Substrat verbunden ist und damit eine hermetische Versiegelung der Funktionsschichten gegenüber der Umgebung erfolgt.

In der Regel werden zur Entfernung der Funktionsschichten im Randbereich des Moduls mechanische Verfahren, wie Strahlen mit Korund oder Schleifen mit Schleifscheiben, angewandt. So wird, wenn wie üblich das Substrat aus Glas besteht, die Glasoberfläche in einer Tiefe von wenigen µm bis einigen zehn µm abgetragen und deutlich mit Mikrorissen geschädigt. Dies kann negative Auswirkung auf die mechanische Festigkeit der Glasscheibe haben. Gravierender allerdings ist der Einfluss der mechanischen Bearbeitung auf die Leitfähigkeit der Glasoberfläche nach Einwirkung von Feuchtigkeit.

Bestimmt man den Oberflächenwiderstand von Kalk-Natron-Glas nach einer Oberflächenbearbeitung, beispielsweise durch Korundstrahlen, findet man mit etwa 14¹³Ohm/Square ähnliche Werte wie für unverarbeitete Glasoberflächen. Werden die Proben jedoch in Anlehnung an die IEC-Norm 61646 für 1000h einem Dampf/Hitze-Test bei 85°C und 85% relativer Feuchte unterworfen, so sinkt der Oberflächenwiderstand der gestrahlten Oberfläche auf 2x10⁹ bis 10¹⁰Ohm/Square, während der Widerstand für die unbearbeitete Glasoberfläche bei etwa 10¹³Ohm/Square nahezu unverändert bleibt.

Für ein photovoltaisches Modul mit einer Fläche von 1 qm und einem Umfang von 4 Metern mit einer Randentschichtung von 2 cm breite ergibt sich demnach ein Isolationswiderstand gegenüber Erde an der Kante des Solarmoduls von nur 10 bis 50MOhm. Gemäß der erwähnten IEC-Norm wird jedoch nach dem Dampf/Hitze-Test ein Isolationswiderstand von mindestens 40MOhm x m² gefordert, so dass mit einer mechanischen Randentschichtung das Risiko besteht, die IEC-Qualifikation bezüglich Isolationsfestigkeit nicht zu bestehen. Dies gilt insbesondere für große Module mit entsprechend großem Umfang.

Aus EP 1 005 096 A2 geht hervor, dass die Funktionsschichten im Randbereich außer durch das mechanische Verfahren auch mit einem Laser entfernt werden können. Dazu wird ein YAG-Laser verwendet, der Laserlicht mit einer Wellenlänge von 532 nm im sichtbaren Bereich emittiert, also ein Neodym dotierter Laser. Damit kann die Frontelektrodenschicht jedoch nicht abgetragen werden. Denn, wenn der Laserstrahl auf die Rückelektrodenschicht fokussiert wird, tritt von vornherein eine vollständige Absorption des Laserlichts durch die Rückelektrodenschicht bzw. die Halbleiterschicht ein. Ebenso wenig wird die Frontelektrodenschicht abgetragen, wenn der Laserstrahl durch das Glassubstrat eintritt, da der Laserstrahl aufgrund der Transparenz der Frontelektrodenschicht nicht absorbiert wird.

Aufgabe der Erfindung ist es daher, ein Verfahren zur Randentschichtung bei der Herstellung photovoltaischer Module bereitzustellen, das einerseits eine hohe Produktivität aufweist und andererseits zu Modulen hoher Isolationsfestigkeit führt.

Dies wird erfindungsgemäß dadurch erreicht, dass zum Entfernen der drei Funktionsschichten im Randbereich des Moduls ein Laser verwendet wird, der eine Infrarotstrahlung emittiert.

Überraschenderweise können nämlich mit einem solchen Laser alle drei Funktionsschichten entfernt werden, obgleich die Halbleiterschicht die Infrarotstrahlung nicht absorbiert.

Die Absorption der Laserstrahlung durch die Frontelektrodenschicht hat nämlich zur Folge, dass die Frontelektrodenschicht durch die Laserstrahlung so aufgeheizt wird, dass sowohl die darüber liegende Halbleiterschicht wie die Rückelektrodenschicht, die ebenfalls die Laserstrahung absorbiert, entfernt werden.

Das transparente Substrat kann eine Glasscheibe sein oder aus einem anderen elektrisch isolierenden transparenten Material bestehen.

Die Frontelektrodenschicht kann aus einem elektrisch leitfähigem Metalloxid, beispielsweise Zinnoxid (SnO₂), insbesondere fluordotiertem Zinnoxid oder einem anderen Material bestehen. Wesentlich ist nur, dass es transparent und elektrisch leitfähig ist, und vorzugsweise mindestens 0,5 %, insbesondere mindestens 2 % der emittierten infraroten Strahlung des Lasers absorbiert.

Die Halbleiterschicht kann aus Silizium beispielsweise amorphem, nano-, mikro- oder polykristallinem Silizium bestehen, aber auch ein anderer Halbleiter, wie Cadmium-Tellur oder CIGS, also Kupfer-Indium-Gallium-Selenid sein.

Die Rückelektrodenschicht ist vorzugsweise eine Metallschicht, beispielsweise aus Aluminium, Kupfer, Silber oder dergleichen.

Die Klebefolie kann eine EVA- oder PVB-Folie oder eine andere Schmelzklebefolie sein. Die Rückenseitenabdeckung, die mit der Klebefolie auf das beschichtete Substrat laminiert wird, kann eine weitere Glasscheibe oder beispielsweise eine Kunststofffolie oder -platte sein.

Das beschichtete Substrat und die Rückenseitenabdeckung mit der Klebefolie als Zwischenschicht werden dann unter erhöhtem Druck und im allgemeinen erhöhter Temperatur laminiert, so dass, wenn das Substrat und die Rückenseitenabdeckung jeweils durch eine Glasscheibe gebildet werden, im Randbereich ein Verbundglas gebildet wird.

Da die Rückenseitenabdeckung und die Klebefolie auch den Randbereich des Substrats entlang des gesamten Umfangs des Moduls bedecken, an dem die Funktionsschichten entfernt worden sind, werden die Funktionsschichten in dem Modul gegenüber der Umgebung einwandfrei versiegelt.

Der erfindungsgemäß eingesetzte Laser emittiert eine Infrarotstrahlung, also eine Strahlung mit einer Wellenlänge von mindestens 800nm, vorzugsweise mindestens 1000 nm, insbesondere wird ein im nahen Infrarotbereich emittierender Festkörperlaser verwendet. Der Festkörperlaser kann auch ein Faserlaser oder ein Scheibenlaser sein.

Vorzugsweise ist der Festkörperlaser ein Nd:YAG-Laser, d.h. er weist als Wirtskristall Yttrium-Aluminium-Granat auf. Stattdessen kann der Wirtskristall beispielsweise auch ein Yttrium-Vanadat(YVO₄) sein. Zur Dotierung wird vorzugsweise Neodym verwendet, also ein Festkörperlaser mit einer Wellenlänge von 1064 nm eingesetzt. Ggf. kann auch Erbium, Ytterbium oder ein anderes Element zur Dotierung verwendet werden.

Zur Entfernung der Funktionsschichten am Randbereich des beschichteten Substrats wird der Laserstrahl durch das transparente Substrat hindurch auf die Funktionsschichten fokussiert. Der Laserstrahl kann jedoch auch von der Schichtseite, also der gegenüberliegenden Seite auf die Funktionsschichten fokussiert werden.

Um eine zuverlässige Schichtablation zu gewährleisten, sollte die Energiedichte des auf die Funktionsschichten fokussierten Laserstrahls mindestens 20mJ/mm² betragen, insbesondere mindestens 50 mJ/mm².

Vorzugsweise wird ein Laser verwendet, der kurze Laserpulse von weniger als 200ns, insbesondere weniger als 100 ns emittiert. Bei längeren Laserpulsen besteht die Gefahr, dass das zu entfernende Material zum Teil nur erhitzt und nur zum Teil entfernt wird und zudem die thermische Energie des erhitzten Materials die Substratoberfläche beschädigt.

Die Leistung des Lasers sollte mindestens 100W und die Pulswiederholungsrate mindestens 1kHz betragen. Die Laserspots können dabei mit geringer Überlappung unmittelbar aneinander gesetzt werden. Die relative Geschwindigkeit zwischen Laserstrahl und Glasoberfläche sollte dazu mindestens 1000 mm/s betragen.

So kann eine erfolgreiche Ablation der Funktionsschichten mit einer Abtragrate von 2000 mm²/s beispielsweise mit einer Laserstrahlenergiedichte von 50 mJ/mm², einer Laserspotfläche von 1mm², einer Laserleistung von 100W und einer Pulswiederholungsrate von 2kHz durchgeführt werden.

Wenn als Substratglas beispielsweise ein Kalk-Natron-Glas verwendet wird, beträgt der Oberflächenwiderstand der mit dem Laser erfindungsgemäß entschichteten Glasoberfläche mehr als 10¹⁰ Ohm/Square, vorzugsweise mehr als 10¹¹ Ohm/Square, insbesondere mehr als 10¹² Ohm/Square, und zwar sowohl unmittelbar nach der Bearbeitung als auch nach einem Dampf/Hitze-Test bei 85°C und 85% relativer Feuchte für 1000 Stunden.

Die beschichtete Glasoberfläche zeichnet sich weiter dadurch aus, dass sie nicht verletzt ist, also keine Mikrorisse oder Ausmuschelungen aufweist. Zwar sind zumindest im Mikroskop spurenartige Materialreste der Funktionsschichten sichtbar, sie sind jedoch ohne negativen Einfluss auf den Oberflächenwiderstand.

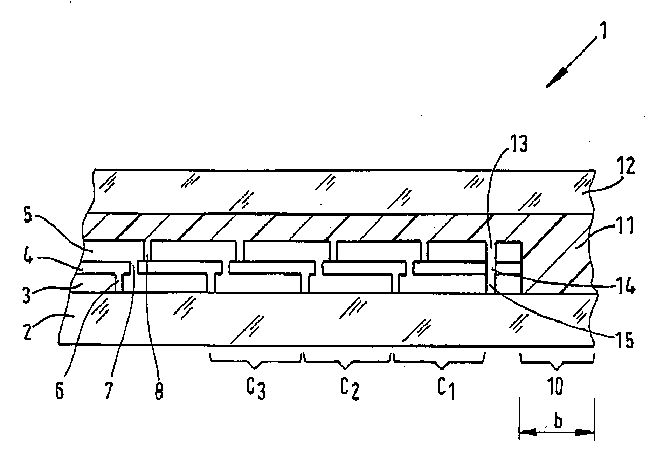

Nachstehend ist die Erfindung anhand der beigefügten Zeichnung beispielhaft näher erläutert, deren einzige Figur den Schnitt durch den Teil eines photovoltaischen Moduls mit dem Randbereich zeigt, wobei die Funktionsschichten stark vergrößert wiedergegeben sind.

Danach weist das photovoltaische Modul 1 ein transparentes Substrat 2, z. B. eine Glasscheibe, auf, auf der drei Funktionsschichten, nämlich eine transparente Frontelektrodenschicht 3, eine Halbleiterschicht 4, beispielsweise aus amorphem Silizium a-Si:H, und eine Rückelektrodenschicht 5 aufeinander abgeschieden sind.

Das Modul besteht aus einzelnen streifenförmigen Zellen C₁, C₂ usw., die durch Strukturlinien 6, 7, 8 serienverschaltet sind. Der erzeugte Strom kann durch Kontaktierung der beiden äußeren Zellen des Moduls 1, also der Zelle C₁ und der nicht dargestellten Zelle auf der anderen Seite des Moduls 1 abgenommen werden.

Im Randbereich 10 des Moduls 1, sind die Funktionsschichten 3, 4, 5 entfernt. Dabei kann bei einem Modul mit einer Fläche von lm² die Breite b des Randbereichs beispielsweise 5 Zentimeter betragen.

Mit der Klebefolie 11, vorzugsweise einer Schmelzklebefolie, ist auf die mit den Funktionsschichten 3, 4, 5 versehene Seite des Substrats 2 eine Rückseitensabdeckung 12 beispielsweise eine Glasscheibe auflaminiert. Damit wird das Substrat 2 im Randbereich 10 mit der Klebefolie 11 direkt mit der Rückseitenabdeckung 12 fest verbunden, wodurch die Funktionsschichten 3 bis 5 in dem Modul 1 versiegelt werden, so dass sie auch bei unterschiedlichen klimatischen Bedingungen, insbesondere bei Feuchtigkeit aber auch Temperaturwechsel von der Umgebung mit einem hohen elektrischen Isolationswiderstand getrennt sind.

Zur Herstellung des Moduls 1 werden die Funktionsschichten 3 bis 5 nacheinander auf dem Substrat vollflächig abgeschieden und jeweils mit den Strukturlinien 6, 7, 8 und den Isolationslinien 13, 14, 15, die die Solarzellen C₁ ,C₂ usw. elektrisch begrenzen/abschließen, versehen. Anschließend werden sie im Randbereich 10 entfernt. Zur Ablation der drei Funktionsschichten 3 bis 5 wird ein Nd:YAG-Festkörperlaser mit seiner Grundwellenlänge von 1064nm verwendet, wobei der Laserstrahl beispielsweise durch das Substrat 2 hindurch auf die Funktionsschicht 3 fokussiert wird.

Anschließend wird die Klebefolie 11 auf das mit den Funktionsschichten 3 bis 5 versehene, im Randbereich 10 aber entschichtete Substrate 12 gelegt und auf die Klebefolie 11 die Rückseitenabdeckung 12, worauf unter Druck und ggf. erhöhter Temperatur laminiert wird, wodurch das gesamte Modul durch die Klebefolie 11 dicht versiegelt wird.

## Patentansprüche

1. Verfahren zur Herstellung eines photovoltaischen Moduls (1), bei dem auf einem transparenten Substrat (2), eine transparente Frontelektrodenschicht (3), eine Halbleiterschicht (4) und eine Rückelektrodenschicht (5) als Funktionsschichten abgeschieden werden, worauf im Randbereich (10) des Moduls (1) die Funktionsschichten (3 - 5) mit einem eine Infrarotstrahlung emittierenden Laser von dem Substrat (2) entfernt werden und dann auf das beschichtete Substrat (2) mit einer Klebefolie (11) eine Rückseitenabdeckung (12) laminiert wird, **dadurch gekennzeichnet, dass** durch eine Energiedichte des auf die Funktionsschichten (3 bis 5) fokussierten Laserstrahls von mindestens 20 mJ/mm² und eine Pulswiderholungsrate des Lasers von mindestens 1 kHz bei auf dem Substrat (2) verbleibenden Materialresten im Randbereich (10) des Moduls (1) die Abtragrate, mit der die Funktionsschichten (3 bis 5) im Randbereich (10) des Moduls (1) entfernt werden, mindestens 1000 mm²/s beträgt.

2. Verfahren nach Anspruch 1, **dadurch gekennzeichnet, dass** ein Neodym dotierter Festkörperlaser mit einer Wellenlänge von 1064 nm zum Entfernen der Funktionsschichten (3 - 5) im Randbereich (10) verwendet wird.

3. Verfahren nach einem der vorstehenden Ansprüche, **dadurch gekennzeichnet, dass** ein gepulster Laser mit Laserpulsen von weniger als 200ns verwendet wird.
